# FASCICULE DE BREVET EUROPEEN

(11) **EP 3 113 235 B1**
(45) Date de publication et mention de la délivrance du brevet: **08.09.2021**
(21) Numéro de dépôt: 16176191.1
(22) Date de dépôt: 24.06.2016
(51) Int. Cl.: H01L 33/20, H01L 33/22

(54) **DISPOSITIF ÉLECTROLUMINESCENT**
ELEKTROLUMINESZENZVORRICHTUNG
ELECTROLUMINESCENT DEVICE

(30) Priorité: 30.06.2015 FR 1556152
(43) Date de publication de la demande: 04.01.2017
(73) Titulaire: Commissariat à l'Energie Atomique et aux Energies Alternatives, 75015 Paris (FR)
(72) Inventeur: Desieres, Yohan, 38000 Grenoble (FR)
(74) Mandataire: Talbot, Alexandre

(56) Documents cités:
- US-A1- 2008 303 047
- US-A1- 2012 280 260
- US-A1- 2012 299 040
- US-A1- 2014 175 474
- US-B1- 6 657 236

## Description

La présente invention a trait à un dispositif électroluminescent pour émettre un rayonnement dans un domaine spectral.

Un dispositif connu de l'état de la technique, comporte successivement :
- un substrat comprenant une couche métallique adaptée pour réfléchir le rayonnement et conduire un courant électrique ;
- une première couche d'un alliage de type III/N, dopée de type p, et comprenant une première surface, en regard de la couche métallique, présentant des cavités ;
- une couche électroluminescente d'un alliage de type III/N, adaptée pour produire le rayonnement ;
- une deuxième couche d'un alliage de type III/N, dopée de type n, par laquelle sort le rayonnement. La deuxième couche présente une surface externe formant une interface avec le milieu de sortie. La surface externe de la deuxième couche est texturée afin d'éviter qu'une majeure partie du rayonnement produit ne soit piégée à l'intérieur du dispositif par réflexions totales internes.

Classiquement, un tel dispositif de l'état de la technique est obtenu par des épitaxies successives de la deuxième couche, de la couche électroluminescente, et de la première couche sur un substrat de croissance, en saphir ou en AlGaN. Puis, la couche métallique est formée sur les couches épitaxiées. L'ensemble est ensuite reporté sur un substrat hôte, bon conducteur de chaleur. Enfin, le substrat de croissance est supprimé par décollement laser (« *Laser Lift-off* » en langue anglaise). La texturation de la surface externe de la deuxième couche est obtenue par une attaque chimique sélective, à base de KOH.

Les désaccords de mailles cristallographiques et de coefficients de dilatation thermique entre le saphir et les alliages de type III/N conduisent à des dislocations à travers les couches épitaxiées. Les dislocations se traduisent par la présence de défauts dans les couches épitaxiées. Plus précisément, les alliages de type III/N possèdent une structure cristalline hexagonale de type wurtzite, et les défauts prennent la forme de cavités, émergentes au niveau des dislocations, tout particulièrement à la première surface de la première couche. Les cavités forment classiquement des motifs creux en pyramide inversée, à base hexagonale (« *V-pits* » en langue anglaise) ; les sommets des pyramides pointent vers une dislocation ou un groupe de dislocations. De telles cavités forment une texturation naturelle de la première surface de la première couche, et sont remplies de métal lors de la formation de la couche métallique.

De telles cavités seraient intéressantes pour l'extraction de lumière, grâce à leur pouvoir diffusant, comme suggéré dans la publication C.M. Tsai et al., « High efficiency and improved ESD characteristics of GaN-based LEDs with naturally textured surface grown by MOCVD », Photonics Technology Letters, IEEE, vol. 18 (11), 2006, pp. 1213-1215.

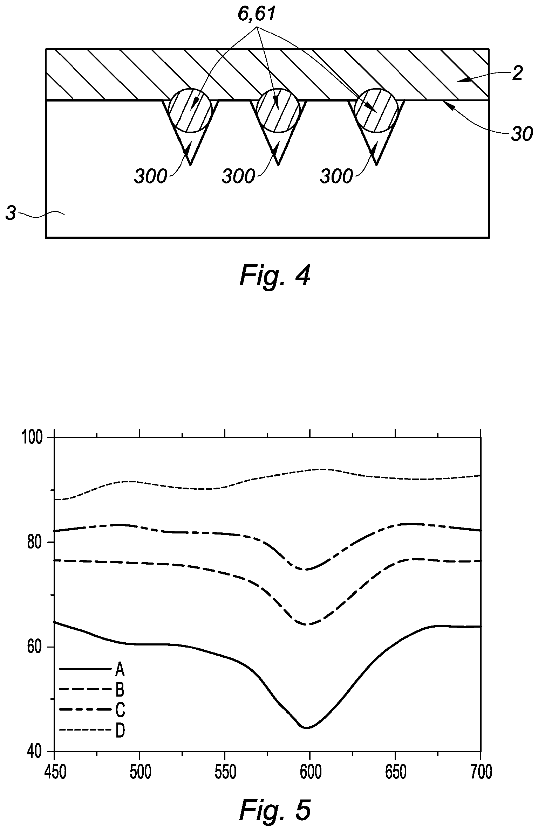

Cependant, comme illustré à la figure 5, la demanderesse a constaté que la réflexion totale, c'est-à-dire spéculaire et diffuse, du rayonnement à l'interface entre la couche métallique et la première surface de la première couche diminue lorsque la densité de cavités augmente, ce qui est préjudiciable pour obtenir un rendement d'extraction de lumière élevé (c'est-à-dire supérieur à 50%) et un rendement du dispositif élevé, le rendement du dispositif étant le rapport entre les watts optiques disponibles et les watts électriques injectés.

Les cavités dans le substrat d'une LED pour l'extraction de lumière, sont aussi divulguées dans le document US 2012/299040 A1.

Ainsi, la présente invention vise à remédier en tout ou partie aux inconvénients précités, et concerne à cet effet un dispositif électroluminescent pour émettre un rayonnement dans un domaine spectral, le dispositif comportant successivement :
- un substrat comprenant une couche métallique adapté pour réfléchir le rayonnement ;
- une première couche d'un alliage de type III/N, dopée de type p, et comprenant une première surface, en regard de la couche métallique, la première surface présentant des cavités ;
- une couche électroluminescente d'un alliage de type III/N, adaptée pour produire le rayonnement ;
- une deuxième couche d'un alliage de type III/N, dopée de type n, par laquelle sort le rayonnement ;
le dispositif étant remarquable en ce qu'un matériau de remplissage, non métallique et transparent dans le domaine spectral, est disposé à l'intérieur des cavités.

Par « domaine spectral », on entend la longueur d'onde ou la bande de longueur d'onde du rayonnement émis. Le domaine spectral appartient préférentiellement au domaine ultraviolet ou visible.

Par « couche métallique », on entend une couche (ou plusieurs sous-couches) d'un matériau métallique, le matériau métallique pouvant être un métal pur ou un alliage métallique.

Par « alliage de type III/N », on entend un nitrure d'au moins un élément situé dans la colonne III du tableau périodique des éléments.

Par « dopé de type p (respectivement n) », on entend que l'alliage correspondant comporte des impuretés adaptées pour favoriser une conduction électrique par des trous (respectivement par des électrons).

Par « transparent », on entend que le matériau de remplissage présente un coefficient d'extinction inférieur ou égal à 0,1 dans le domaine spectral.

Ainsi, un tel dispositif selon l'invention permet, par rapport à l'état de la technique, de réduire les pertes d'absorption à l'interface entre la couche métallique et la première surface de la première couche, et ce grâce à un tel matériau de remplissage. Un tel dispositif selon l'invention permet par là-même d'augmenter la réflexion totale du rayonnement à ladite interface, et donc l'extraction de lumière. Les pertes d'absorption sont d'autant plus réduites que la densité surfacique de cavités à la première surface est élevée. Le matériau de remplissage est non métallique de manière à également éviter un couplage optique entre le rayonnement produit par la couche électroluminescente et des plasmons de surface à la première surface de la première couche.

Dans un mode de réalisation, le matériau de remplissage forme une couche plane s'étendant entre la couche métallique et la première surface de la première couche, et le matériau de remplissage est électriquement conducteur.

Par « électriquement conducteur », on entend que le matériau de remplissage présente une conductivité électrique à 300 K comprise entre 10³ et 10⁴ S/cm.

Ainsi, une telle couche plane, intercalée entre la première surface de la première couche et la couche métallique, permet d'éviter un aplanissement de la première surface de la première couche (par exemple par polissage mécano-chimique), et par là-même d'éviter une dégradation des performances électriques de la première couche. Une telle couche plane empêche tout contact direct entre la première surface de la première couche et la couche métallique. Le matériau de remplissage est donc électriquement conducteur pour permettre la polarisation du dispositif.

Avantageusement, le matériau de remplissage est un oxyde, de préférence sélectionné dans le groupe comportant l'oxyde d'indium-étain, l'oxyde de zinc ZnO dopé à l'aluminium, à l'indium ou au gallium.

Ainsi, de tels matériaux sont à la fois électriquement conducteurs et présentent un indice optique proche de celui d'un alliage de type III/N, par exemple le GaN (n=2,45 à 450 nm). En outre, de tels oxydes transparents conducteurs peuvent être formés simplement à la première surface de la première couche. L'oxyde d'indium-étain est particulièrement avantageux car c'est un excellent injecteur de trous.

Dans un mode de réalisation, le matériau de remplissage affleure la première surface de la première couche, et la première surface de la première couche est en contact avec la couche métallique.

Ainsi, une plus grande liberté sur le choix du matériau de remplissage est autorisée car la conduction électrique est assurée par la première couche. Le matériau de remplissage peut donc être un matériau électriquement conducteur ou un matériau diélectrique.

Par « diélectrique », on entend que le matériau de remplissage présente une conductivité électrique à 300 K strictement inférieure à 10⁻⁸ S/cm.

Par « affleure », on entend que le matériau de remplissage :
- arrive au niveau de la première surface de la première couche, ou
- est en saillie ou en retrait de la première surface de la première couche avec une distance maximale inférieure ou égale à 10 nm.

Avantageusement, le matériau de remplissage est sélectionné dans le groupe comportant le dioxyde de titane TiO₂, le dioxyde de silicium SiO₂, l'oxyde de zinc ZnO, l'oxyde de zinc ZnO dopé à l'aluminium, à l'indium ou au gallium, le nitrure de silicium SiN, l'oxyde d'indium-étain.

Ainsi, de tels matériaux de remplissage présentent un indice optique proche de celui d'un alliage de type III/N, par exemple le GaN (n=2,45 à 450 nm), et peuvent être formés simplement à l'intérieur des cavités.

Dans un mode de réalisation, le matériau de remplissage forme des billes diélectriques, et la première surface de la première couche est en contact avec la couche métallique.

De telles billes diélectriques sont avantageusement formées par une évaporation d'une suspension colloïdale.

Avantageusement, le matériau de remplissage est sélectionné dans le groupe comportant le dioxyde de titane TiO₂, le nitrure de silicium SiN, le dioxyde de silicium SiO₂, l'oxyde de zinc ZnO.

Avantageusement, la couche métallique est à base d'argent ou d'aluminium.

Avantageusement, l'alliage des première et deuxième couches et de la couche électroluminescente est un alliage binaire ou un alliage ternaire, l'alliage binaire étant de préférence à base de GaN, l'alliage ternaire étant de préférence à base d'InGaN ou d'AlGaN.

Avantageusement, les cavités présentent une densité surfacique supérieure à 10⁸ cm⁻² à la première surface de la première couche.

D'autres caractéristiques et avantages apparaîtront dans la description qui va suivre de différents modes de réalisation de l'invention, donnés à titre d'exemples non limitatifs, en référence aux dessins annexés dans lesquels :
- la figure 1 est une vue schématique en perspective d'un dispositif selon l'invention,
- la figure 2 est une vue schématique partielle en coupe d'un dispositif selon un premier mode de réalisation de l'invention,
- la figure 3 est une vue schématique partielle en coupe d'un dispositif selon un deuxième mode de réalisation de l'invention,
- la figure 4 est une vue schématique partielle en coupe d'un dispositif selon un troisième mode de réalisation de l'invention,
- la figure 5 (déjà commentée) est un graphique représentant la réflectivité totale de l'interface entre la couche métallique (en Ag) et la première surface de la première couche (en GaN) d'un dispositif de l'état de la technique (axe des ordonnées, en %) en fonction de la longueur d'onde du rayonnement émis (axe des abscisses, en nm), pour différentes densités d de cavités (A : d=2.10⁹ cm⁻², B : d=10⁹ cm⁻², C : d=2.10⁸ cm⁻², D : d=0),
- la figure 6 est une vue schématique partielle en coupe d'un dispositif selon le premier mode de réalisation illustrant la couche métallique,
- la figure 7 est une vue schématique partielle en coupe d'un dispositif selon le deuxième mode de réalisation illustrant la couche métallique,
- la figure 8 est une vue schématique partielle en coupe d'un dispositif selon le troisième mode de réalisation illustrant la couche métallique.

Pour les différents modes de réalisation, les mêmes références seront utilisées pour des éléments identiques ou assurant la même fonction, par souci de simplification de la description. Les caractéristiques techniques décrites ci-après pour différents modes de réalisation sont à considérer isolément ou selon toute combinaison techniquement possible.

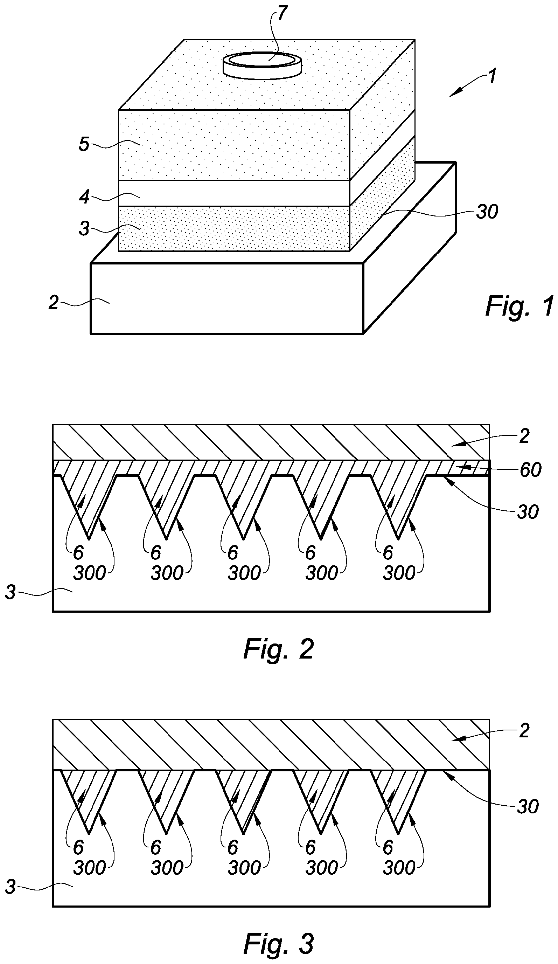

Le dispositif illustré aux figures 1 à 8 est un dispositif 1 électroluminescent pour émettre un rayonnement dans un domaine spectral, le dispositif comportant successivement :
- un substrat 2 comprenant une couche métallique 20 adaptée pour réfléchir le rayonnement ;
- une première couche 3 d'un alliage de type III/N, dopée de type p, et comprenant une première surface 30, en regard de la couche métallique 20, la première surface 30 présentant des cavités 300 ;
- une couche électroluminescente 4 d'un alliage de type III/N, adaptée pour produire le rayonnement ;
- une deuxième couche 5 d'un alliage de type III/N, dopée de type n, par laquelle sort le rayonnement.

Un matériau de remplissage 6, non métallique et transparent dans le domaine spectral, est disposé à l'intérieur des cavités 300. Le matériau de remplissage 6 est différent du matériau du substrat 2.

Un plot de contact 7 est avantageusement formé sur la deuxième couche 5.

Le dispositif 1 est préférentiellement une diode électroluminescente, plus préférentiellement à technologie VTF (pour *Vertical Thin Film* en langue anglaise) ou à technologie TFFC (pour *Thin Film Flip Chip*). Le domaine spectral est préférentiellement le domaine ultraviolet ou visible, compris entre 200 nm et 780 nm.

La couche métallique 20 est d'un matériau métallique, le matériau métallique étant un métal pur ou un alliage métallique. Le matériau métallique est avantageusement à base d'argent ou d'aluminium. La couche métallique 20 peut comporter des sous-couches d'un matériau métallique. La couche métallique 20 forme un miroir réflecteur adapté pour réfléchir le rayonnement. La couche métallique 20 présente avantageusement un coefficient de réflexion supérieure à 0,8, préférentiellement supérieur à 0,9, afin d'obtenir un rendement d'extraction optique élevé. La couche métallique 20 est adaptée pour conduire un courant électrique. La couche métallique 20 permet la polarisation du dispositif 1 par injection de porteurs.

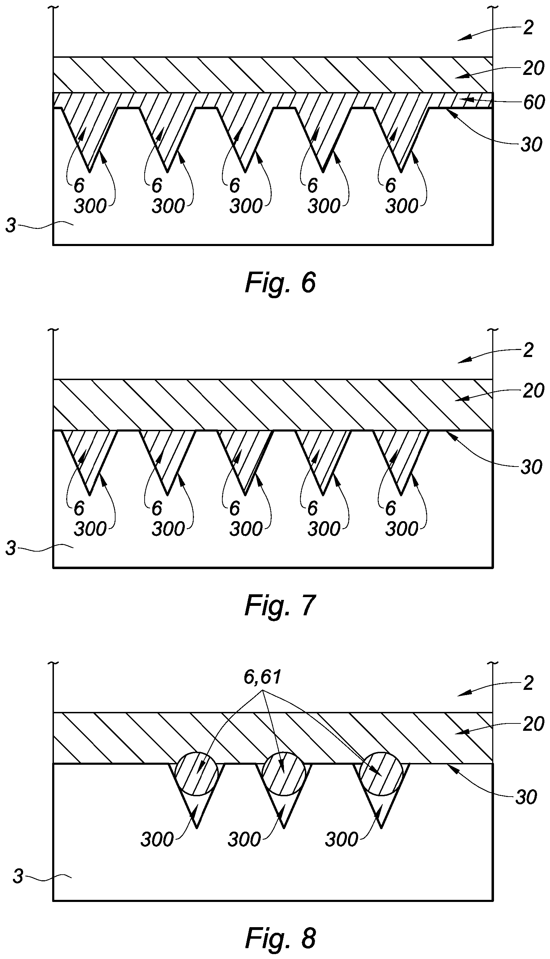

La couche métallique 20 s'étend au moins partiellement en contact avec le matériau de remplissage 6. La couche métallique 20 s'étend entre le substrat 2 et le matériau de remplissage 6. En d'autres termes, le dispositif 1 comporte successivement le substrat 2, la couche métallique 20, le matériau de remplissage 6, la première couche 3, comme illustré aux figures 6 à 8.

L'alliage des première et deuxième couches 3, 5 et de la couche électroluminescente 4 est avantageusement un alliage binaire ou un alliage ternaire, l'alliage binaire étant de préférence à base de GaN, l'alliage ternaire étant de préférence à base d'InGaN ou d'AlGaN. La couche électroluminescente 4 peut comporter des sous-couches électroluminescentes. La deuxième couche 5 présente une surface externe formant une interface avec le milieu de sortie. La surface externe de la deuxième couche 5 est avantageusement texturée afin d'éviter qu'une majeure partie du rayonnement produit ne soit piégée à l'intérieur du dispositif 1 par réflexions totales internes. La texturation de la surface externe de la deuxième couche 5 est préférentiellement obtenue par une attaque chimique sélective, à base de KOH. Les première et deuxième couches 3, 5 et la couche électroluminescente 4 sont préférentiellement formées sur un substrat de croissance par épitaxie. Le substrat de croissance est de préférence en saphir lorsque le domaine spectral est le visible ; le substrat de croissance est de préférence en AlGaN lorsque le domaine spectral est l'ultraviolet. Après la formation de la couche métallique 20 et du report de l'ensemble sur le substrat 2 (substrat hôte), le substrat de croissance est préférentiellement supprimé par décollement laser (« *Laser Lift-off* » en langue anglaise).

Les cavités 300 forment des motifs creux en pyramide inversée, généralement à base hexagonale (« *V-pits* » en langue anglaise, la section étant en forme de V). Les sommets des pyramides pointent vers une dislocation ou un groupe de dislocations. Les cavités 300 présentent généralement une densité surfacique comprise entre 10⁸ et 10¹⁰ cm⁻² à la première surface 30 de la première couche 3. La demanderesse a constaté que la réflexion totale, c'est-à-dire spéculaire et diffuse, du rayonnement à l'interface entre la couche métallique 20 et la première surface 30 de la première couche 3 diminue significativement à partir d'une densité surfacique de l'ordre de 10⁸ cm⁻². Les cavités 300 présentent une profondeur (c'est-à-dire la hauteur de la pyramide) de l'ordre de 150 nm, et un diamètre (c'est-à-dire le diamètre de l'hexagone, sensiblement régulier, formant la base de la pyramide) de l'ordre de 100 nm.

Dans un mode de réalisation illustré à la figure 2, le matériau de remplissage 6 forme une couche plane 60 s'étendant entre la couche métallique 20 et la première surface 30 de la première couche 3, et le matériau de remplissage 6 est électriquement conducteur. Le matériau de remplissage 6 est avantageusement un oxyde, de préférence sélectionné dans le groupe comportant l'oxyde d'indiumétain, l'oxyde de zinc ZnO dopé à l'aluminium, à l'indium ou au gallium. Le niveau de dopage est adapté selon le niveau de conduction désiré. Le matériau de remplissage 6 est déposé sur la première surface 30 de la première couche 3 avant la formation de la couche métallique 20. La couche plane 60 est avantageusement obtenue par un polissage mécano-chimique. La couche plane 60 empêche tout contact direct entre la première couche 3 et la couche métallique 20.

Dans un mode de réalisation illustré à la figure 3, le matériau de remplissage 6 affleure la première surface 30 de la première couche 3, et la première surface 30 de la première couche 3 est en contact avec la couche métallique 20. Le matériau de remplissage 6 est déposé sur la première surface 30 de la première couche 3 avant la formation de la couche métallique 20. Puis l'affleurement est préférentiellement obtenu par un polissage mécano-chimique du matériau de remplissage 6 jusqu'à la première surface 30 de la première couche 3. Le matériau de remplissage 6 est avantageusement sélectionné dans le groupe comportant le dioxyde de titane TiO₂, le dioxyde de silicium SiO₂, l'oxyde de zinc ZnO, l'oxyde de zinc ZnO dopé à l'aluminium, le nitrure de silicium SiN, l'oxyde d'indium-étain. La couche métallique 20 est en contact direct avec la première couche 3 et le matériau de remplissage 6.

Dans un mode de réalisation illustré à la figure 4, le matériau de remplissage 6 forme des billes diélectriques 61, et la première surface 30 de la première couche 3 est en contact avec la couche métallique 20. De telles billes diélectriques 61 sont avantageusement formées par une évaporation d'une suspension colloïdale, dont un exemple de mise en œuvre est donné dans le document T. Pinedo et al, « Assisted convective-capillary force assembly of gold colloids in a microfluid ce// : Plasmonic properties of deterministic nanostructures », J. Vac. Sci. Technol., B 26(6), 2008, p. 2513-2519. Ce mode de réalisation est avantageux car un tel matériau de remplissage 6 possède une bonne planéité. Plusieurs billes diélectriques 61 peuvent également occuper une cavité 300. Les billes diélectriques 61 présentent avantageusement un rayon compris entre 2 nm et 20 nm de sorte que le matériau de remplissage 6 est en saillie ou en retrait de la première surface 30 de la première couche 3 avec une distance maximale inférieure ou égale à 10 nm. Une rugosité du matériau de remplissage 6 supérieure à 10 nm dégrade significativement la réflexion du rayonnement à l'interface entre le matériau de remplissage 6 et la couche métallique 20 en augmentant l'absorption. En outre, un tel rayon de billes diélectriques 61, très inférieur à la taille des cavités 300, permet à plusieurs billes diélectriques 61 d'occuper une cavité 300, ce qui permet une adaptation à différentes tailles de cavités 300. Par ailleurs, on recherchera une taille de bille diélectrique 61 la plus faible possible. Le matériau de remplissage 6 est avantageusement sélectionné dans le groupe comportant le dioxyde de titane TiO₂, le nitrure de silicium SiN, le dioxyde de silicium SiO₂, l'oxyde de zinc ZnO.

## Revendications

1. Dispositif (1) électroluminescent pour émettre un rayonnement dans un domaine spectral, le dispositif (1) comportant successivement :
- un substrat (2) comprenant une couche métallique (20) adaptée pour réfléchir le rayonnement ;
- une première couche (3) d'un alliage de type III/N, dopée de type p, et comprenant une première surface (30), en regard de la couche métallique (20), la première surface (30) présentant des cavités (300) ;
- une couche électroluminescente (4) d'un alliage de type III/N, adaptée pour produire le rayonnement ;
- une deuxième couche (5) d'un alliage de type III/N, dopée de type n, par laquelle sort le rayonnement ;
le dispositif (1) étant **caractérisé en ce qu'**un matériau de remplissage (6), non métallique et transparent dans le domaine spectral, est disposé à l'intérieur des cavités (300).

2. Dispositif (1) selon la revendication 1, **caractérisé en ce que** le matériau de remplissage (6) forme une couche plane (60) s'étendant entre la couche métallique (20) et la première surface (30) de la première couche (3), et **en ce que** le matériau de remplissage (6) est électriquement conducteur.

3. Dispositif (1) selon la revendication 2, **caractérisé en ce que** le matériau de remplissage (6) est un oxyde, de préférence sélectionné dans le groupe comportant l'oxyde d'indium-étain, l'oxyde de zinc ZnO dopé à l'aluminium, à l'indium, ou au gallium.

4. Dispositif (1) selon la revendication 1, **caractérisé en ce que** le matériau de remplissage (6) affleure la première surface (30) de la première couche (3), et **en ce que** la première surface (30) de la première couche (3) est en contact avec la couche métallique (20).

5. Dispositif (1) selon la revendication 4, **caractérisé en ce que** le matériau de remplissage (6) est sélectionné dans le groupe comportant le dioxyde de titane TiO₂, le dioxyde de silicium SiO₂, l'oxyde de zinc ZnO, l'oxyde de zinc ZnO dopé à l'aluminium, à l'indium ou au gallium, le nitrure de silicium SiN, l'oxyde d'indiumétain.

6. Dispositif (1) selon la revendication 1, **caractérisé en ce que** le matériau de remplissage (6) forme des billes diélectriques (61), et **en ce que** la première surface (30) de la première couche (3) est en contact avec la couche métallique (20).

7. Dispositif (1) selon la revendication 6, **caractérisé en ce que** le matériau de remplissage (6) est sélectionné dans le groupe comportant le dioxyde de titane TiO₂, le nitrure de silicium SiN, le dioxyde de silicium SiO₂, l'oxyde de zinc ZnO.

8. Dispositif (1) selon l'une des revendications 1 à 7, **caractérisé en ce que** la couche métallique (20) est à base d'argent ou d'aluminium.

9. Dispositif (1) selon l'une des revendications 1 à 8, **caractérisé en ce que** l'alliage des première et deuxième couches (3, 4) et de la couche électroluminescente (4) est un alliage binaire ou un alliage ternaire, l'alliage binaire étant de préférence à base de GaN, l'alliage ternaire étant de préférence à base d'InGaN ou d'AlGaN.

10. Dispositif (1) selon l'une des revendications 1 à 9, **caractérisé en ce que** les cavités (300) présentent une densité surfacique supérieure à 10⁸ cm⁻² à la première surface (30) de la première couche (3).

## Patentansprüche

1. Elektrolumineszierende Vorrichtung (1), um eine Strahlung in einem Spektralbereich zu emittieren, wobei die Vorrichtung (1) nacheinander umfasst:
- ein Substrat (2), umfassend eine metallische Schicht (20), die dazu vorgesehen ist, die Strahlung zu reflektieren;
- eine erste Schicht (3) einer Legierung des Typs III/N, dotiert des Typs p, umfassend eine erste Fläche (30) gegenüber der metallischen Schicht (20), wobei die erste Fläche (30) Hohlräume (300) aufweist;
- eine elektrolumineszierende Schicht (4) einer Legierung des Typs III/N, die dazu vorgesehen ist, die Strahlung zu erzeugen;
- eine zweite Schicht (5) einer Legierung des Typs III/N, dotiert des Typs n, über die die Strahlung austritt;
wobei die Vorrichtung (1) **dadurch gekennzeichnet ist, dass** ein nicht metallisches und im Spektralbereich transparentes Füllmaterial (6) innerhalb der Hohlräume (300) angeordnet ist.

2. Vorrichtung (1) nach Anspruch 1, **dadurch gekennzeichnet, dass** das Füllmaterial (6) eine flache Schicht (60) bildet, die sich zwischen der metallischen Schicht (20) und der ersten Fläche (30) der ersten Schicht (3) erstreckt, und dass das Füllmaterial (6) elektrisch leitend ist.

3. Vorrichtung (1) nach Anspruch 2, **dadurch gekennzeichnet, dass** das Füllmaterial (6) ein Oxid ist, vorzugsweise ausgewählt aus der Gruppe umfassend Indium-Zinn-Oxid, sowie mit Aluminium, Indium oder Gallium dotiertes Zinkoxid ZnO.

4. Vorrichtung (1) nach Anspruch 1, **dadurch gekennzeichnet, dass** das Füllmaterial (6) an die erste Fläche (30) der ersten Schicht (3) angrenzt, und dass die erste Fläche (30) der ersten Schicht (3) mit der metallischen Schicht (20) in Kontakt ist.

5. Vorrichtung (1) nach Anspruch 4, **dadurch gekennzeichnet, dass** das Füllmaterial (6) aus der Gruppe umfassend Titandioxid TiO₂, Siliziumdioxid SiO₂, Zinkoxid ZnO, mit Aluminium, Indium oder Gallium dotiertes Zinkoxid ZnO, Siliziumnitrid SiN, sowie Indium-Zinn-Oxid ausgewählt ist.

6. Vorrichtung (1) nach Anspruch 1, **dadurch gekennzeichnet, dass** das Füllmaterial (6) dielektrische Kugeln (61) bildet, und dass die erste Fläche (30) der ersten Schicht (3) mit der metallischen Schicht (20) in Kontakt ist.

7. Vorrichtung (1) nach Anspruch 6, **dadurch gekennzeichnet, dass** das Füllmaterial (6) aus der Gruppe umfassend Titandioxid TiO₂, Siliziumnitrid SiN, Siliziumdioxid SiO₂, sowie Zinkoxid ZnO ausgewählt ist.

8. Vorrichtung (1) nach einem der Ansprüche 1 bis 7, **dadurch gekennzeichnet, dass** die metallische Schicht (20) auf Basis von Silber oder Aluminium ist.

9. Vorrichtung (1) nach einem der Ansprüche 1 bis 8, **dadurch gekennzeichnet, dass** die Legierung der ersten und zweiten Schichten (3, 4) und der elektrolumineszierenden Schicht (4) eine binäre Legierung oder eine ternäre Legierung ist, wobei die binäre Legierung vorzugsweise auf Basis von GaN ist, und die ternäre Legierung vorzugsweise auf Basis von InGaN oder AlGaN ist.

10. Vorrichtung (1) nach einem der Ansprüche 1 bis 9, **dadurch gekennzeichnet, dass** die Hohlräume (300) auf der ersten Fläche (30) der ersten Schicht (3) eine Flächendichte von mehr als 10⁸ cm⁻² aufweisen.

## Claims

1. Light-emitting device (1) for emitting a radiation in a spectral range, the device (1) successively comprising:
- a substrate (2) comprising a metal layer (20) capable of reflecting the radiation;
- a first layer (3) of a III/N type alloy, p-type doped, and comprising a first surface (30), facing the metal layer (20), the first surface (30) being provided with cavities (300);
- a light-emitting layer (4) of a III/N-type alloy, capable of generating the radiation;
- a second layer (5) of a III/N-type alloy, n-type doped, having the radiation coming out therethrough;
the device (1) being **characterized in that** a filling material (6), non-metallic and transparent in the spectral range, is arranged within the cavities (300).

2. Device (1) according to claim 1, **characterized in that** the filling material (6) forms a planar layer (60) extending between the metal layer (20) and the first surface (30) of the first layer (3), and **in that** the filling material (6) is electrically conductive.

3. Device (1) according to claim 2, **characterized in that** the filling material (6) is an oxide, preferably selected in the group comprising indium-tin oxide, zinc oxide ZnO doped with aluminum, indium, or gallium.

4. Device (1) according to claim 1, **characterized in that** the filling material (6) is flush with the first surface (30) of the first layer (3) and **in that** the first surface (30) of the first layer (3) is in contact with the metal layer (20).

5. Device (1) according to claim 4, **characterized in that** the filling material (6) is selected in the group comprising titanium dioxide TiO₂, silicon dioxide SiO₂, zinc oxide ZnO, zinc oxide ZnO doped with aluminum, indium, or gallium, silicon nitride SiN, indium tin oxide.

6. Device (1) according to claim 1, **characterized in that** the filling material (6) forms dielectric balls (61) and **in that** the first surface (30) of the first layer (3) is in contact with the metal layer (20).

7. Device (1) according to claim 6, **characterized in that** the filling material (6) is selected in the group comprising titanium dioxide TiO₂, silicon nitride SiN, silicon dioxide SiO₂, zinc oxide ZnO.

8. Device (1) according to any of claims 1 to 7, **characterized in that** the metal layer (20) is based on silver or on aluminum.

9. Device (1) according to any of claims 1 to 8, **characterized in that** the alloy of the first and second layers (3, 4) and of the light-emitting layer (4) is a binary alloy or a ternary alloy, the binary alloy being preferably based on GaN, the ternary alloy being preferably based on InGaN or on AIGaN.

10. Device (1) according to any of claims 1 to 9, **characterized in that** the cavities (300) have a surface density greater than 10⁸ cm⁻² at the first surface (30) of the first layer (3).
